Europäisches Patentamt

European Patent Office

Office européen des brevets

(11) Publication number: **0 105 695**
**B1**

# EUROPEAN PATENT SPECIFICATION

(45) Date of publication of patent specification: **31.05.89**

(51) Int. Cl.⁴: **H 01 L 27/06, H 01 L 21/82**

(21) Application number: **83305767.2**

(22) Date of filing: **27.09.83**

(54) MOS/bipolar integrated circuit device and manufacturing method thereof.

(30) Priority: **30.09.82 JP 171823/82**

(43) Date of publication of application:
**18.04.84 Bulletin 84/16**

(45) Publication of the grant of the patent:
**31.05.89 Bulletin 89/22**

(84) Designated Contracting States:
**DE FR GB NL**

(56) References cited:
**DE-A-2 321 426**
**DE-A-3 043 913**
**DE-A-3 123 348**

**PATENTS ABSTRACTS OF JAPAN, vol. 6, no.
176 (E-130)1054r, 10th September 1982; & JP -
A - 57 93 562 (HITACHI SEISAKUSHO K.K.)
10-06-1982**
**PATENTS ABSTRACTS OF JAPAN, vol. 3, no.
124 (E-144)130r, 17th October 1979; & JP - A -
54 101 290 (HITACHI SEISAKUSHO K.K.) 08-09-
1979**

(73) Proprietor: **KABUSHIKI KAISHA TOSHIBA
72, Horikawa-cho Saiwai-ku
Kawasaki-shi Kanagawa-ken 210 (JP)**

(72) Inventor: **Onga, Shinji
1-4-402, Fujigaoka
Fujisawa-shi Kanagawa-ken (JP)**
Inventor: **Dang, Ryo
2513-1334, Shiomidai
Isogo-ku Yokohama-shi (JP)**

(74) Representative: **Freed, Arthur Woolf et al
MARKS & CLERK 57-60 Lincoln's Inn Fields
London WC2A 3LS (GB)**

Courier Press, Leamington Spa, England.

**Description**

The present invention relates generally to an integrated semiconductor device and, more particularly, to a MOS/bipolar semiconductor device having different transistor elements, such as unipolar transistors including metal oxide semiconductor field effect transistors (MOSFETs) and bipolar transistors (e.g., junction transistors), on the same substrate, and to a manufacturing method thereof.

Recently, it is known for those skilled in the art to form different types of transistor elements, such as MOS transistors and bipolar transistors, in a single integrated circuit, thereby achieving a desired technical objective. In order to form, for example, an integrated interface circuit for effectively controlling a considerably large current within such a single circuit, MOS transistors which have low power consumption and are suitable for high packing density are used as control signal sources, while bipolar transistors are used as elements through which the high currents to be controlled flow. In such a case, an output control signal from the MOS transistor is supplied to the base of the bipolar transistor.

In a conventional semiconductor integrated circuit device having a heterostructure of the different types of transistors described above, MOS and bipolar transistors are two-dimensionally formed on a major surface of the same semiconductor substrate. In this case, three problems are presented:

(1) The area of the substrate surface on which the bipolar transistors are formed is larger than that of the MOS transistors, so that the bipolar transistors cannot achieve high packing density, thereby increasing the size of the substrate.

(2) The manufacturing process of MOS transistors differs in principle from that of bipolar transistors, so that the manufacturing process becomes complicated when different types of transistors are formed on the same substrate.

(3) The thermal hysteresis in the epitaxial growth technique is prolonged, so that an impurity profile provided at the initial step of the manufacturing process causes redistribution, thereby degrading electrical characteristics of the element.

In problem (3), when epitaxial growth is initiated in the bipolar element region of the substrate adjacent to the MOS element region, auto-doping and/or out-diffusion causes an impurity to diffuse from a prospective epitaxial buried layer into an undesirable portion of the MOS element region of the substrate. Therefore, the manufacturing process of the bipolar transistors adversely affects the MOS transistors.

JP—A—5793562 discloses a semiconductor device in which a MOS FET is stacked above a bipolar transistor formed in the substrate.

It is therefore an object of the present invention to provide a new and improved semiconductor device and a manufacturing method thereof wherein MOS transistors and bipolar transistors are formed on the same substrate in a high packing density and degradation of electrical characteristics can be prevented.

According to the invention, there is provided a semiconductor device using bipolar transistors as first active elements for directly controlling currents, and unipolar transistors as second active elements for supplying control signals to said bipolar transistors, said unipolar and bipolar transistors having different operating modes and being formed on a single semiconductor substrate, characterised in that said unipolar transistors included in said integrated circuit are directly formed in said substrate, that said bipolar transistors are stacked above said unipolar transistors and that an electrical insulating layer is formed on the unipolar transistors so as to be sandwiched between the unipolar transistors and as a single-crystalline semiconductor layer in which said bipolar transistors are formed, said insulating layer being provided with at least one opening in a portion corresponding to the drain region of at least one said unipolar transistor through which said single-crystalline layer is in contact with said drain.

The present invention may be best understood with reference to the accompanying drawings, in which:

Fig. 1A is a plan view partially showing the structure of a field insulation layer formed on the substrate when a MOS/bipolar IC device according to an embodiment of the present invention is manufactured;

Fig. 1B is a sectional view partially showing the structure shown in Fig. 1A, taken along line 1B—1B thereof;

Fig. 2A is a plan view partially showing the semiconductor device wherein a gate insulation film having a contact hole is formed;

Fig. 2B is a sectional view partially showing the structure shown in Fig. 2A, taken along line 2B—2B thereof;

Fig. 3A is a plan view partially showing the semiconductor device wherein a patterned polycrystalline silicon layer and a source-drain region of the MOS transistor are further formed;

Figs. 3B and 3C are sectional views showing the structure of Fig. 3A, taken along lines 3B—3B and 3C—3C, respectively;

Figs. 4A is a plan view partially showing the semiconductor device wherein a polycrystalline silicon layer is further formed;

Figs. 4B and 4C are sectional views showing the structure of Fig. 4A, taken along lines 4B—4B and 4C—4C, respectively;

Fig. 5A is a plan view partially showing the semiconductor device wherein the polycrystalline silicon layer is converted by recrystallization to a single-crystalline silicon layer and the single-crystalline silicon layer is then patterned to provide a prospective element formation region of bipolar transistors;

Figs. 5B and 5C are sectional views showing the structure of Fig. 5A, taken along lines 5B—5B and 5C—5C, respectively;

Fig. 6A is a plan view partially showing the semiconductor device wherein bipolar transistors are formed above the MOS transistors;

Figs. 6B, 6C and 6D are sectional views showing the structure of Fig. 6A, taken along lines 6B—6B, 6C—6C, and 6D—6D, respectively;

Fig. 7 is a circuit diagram partially showing an equivalent circuit of the MOS/bipolar IC device shown in Fig. 6A; and

Fig. 8 is a graph showing the measured electrical characteristics of the IC device shown in Fig. 6.

In an integrated circuit (IC) device including unipolar transistors, such as metal oxide semiconductor field effect transistors (MOSFETs), and bipolar transistors, such as junction transistors, according to the present invention, only the MOS transistors are directly formed in a single-crystalline semiconductor substrate, while the bipolar transistors are formed above the MOS transistors through an insulating layer, in a two-storied structure. To clearly disclose the IC device having this structure a description will be made with reference to the manufacturing steps of the device.

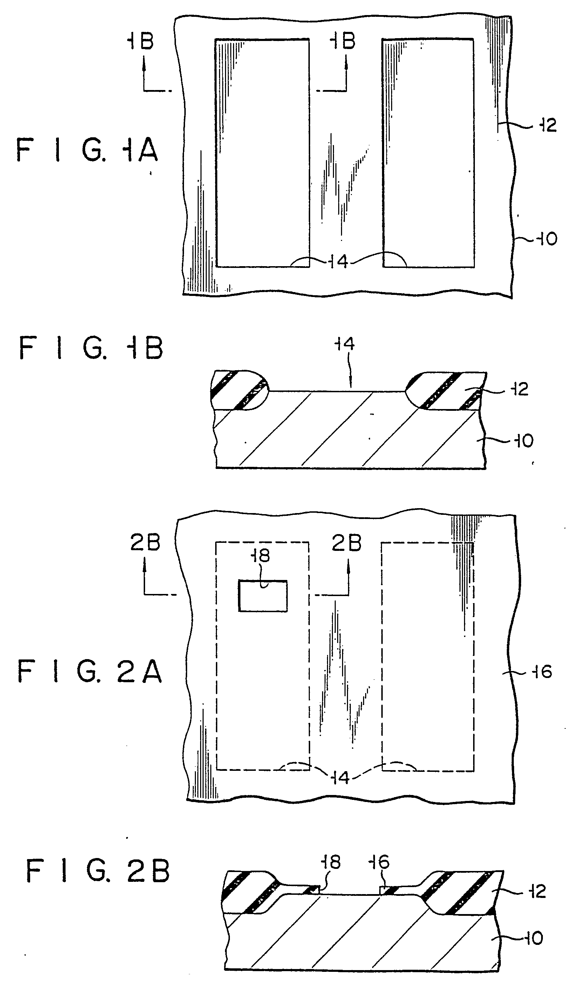

An insulating layer or field insulation layer 12 having rectangular windows 14 is formed on an n-type single crystalline semiconductor substrate 10 containing, e.g., phosphorus as an impurity, in a concentration of $1.5 \times 10^{15}$ cm$^{-3}$, as shown in Fig. 1A. The windows 14 correspond to element formation regions of MOS transistors such as enhancement-type MOS transistors. Fig. 1B illustrates a sectional view of the structure of Fig. 1A taken along the line 1B—1B thereof. It should be noted that these drawings are not drawn to scale.

Subsequently, the structure shown in Fig. 1 is exposed in a dry atmosphere at a predetermined temperature (i.e., at a high temperature of 900°C), to deposit a gate oxide film 16 thereon to a thickness of about 50nm (500 Å), as shown in Figs. 2A and 2B. A rectangular opening 18 corresponding to a contact hole of the drain region of an MOS transistor is formed within each element formation region 14. P-type impurity ions such as boron ions are injected into the substrate 10 through the opening 18, at a dose of $4 \times 10^{15}$ cm$^{-2}$ and an ion acceleration voltage of 40 keV, thereby decreasing the resistance of the drain region of the substrate.

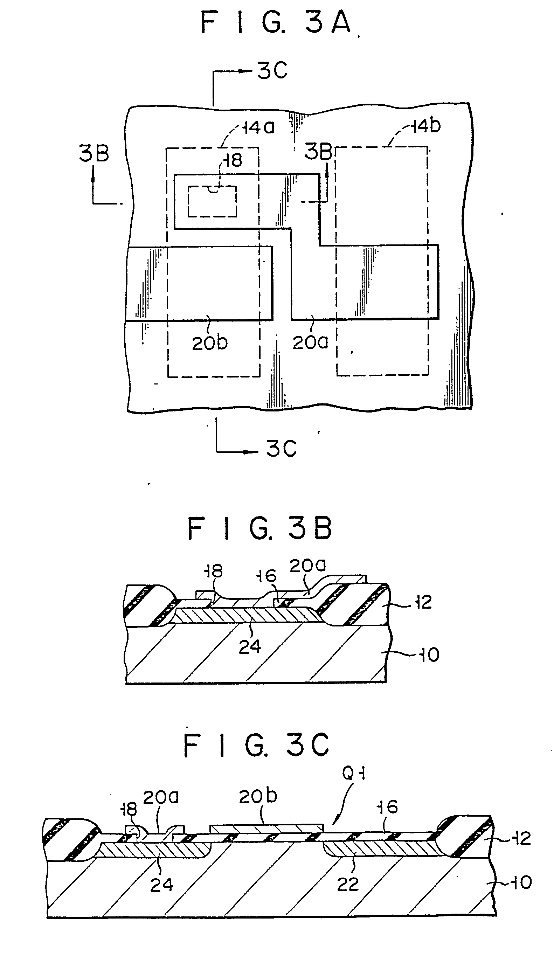

Thereafter, a polycrystalline silicon film 20 having a thickness of, e.g., 300nm (3,000 Å) is deposited by a known reduced-CVD method to cover the entire surface of the structure shown in Figs. 2A and 2B. The polycrystalline silicon film 20 is patterned, as shown in Figs. 3A to 3C, thereby obtaining patterned films 20a and 20b. In this embodiment, the patterend polycrystalline silicon film 20a contacts the drain region of one MOS transistor formation region 14a through the contact hole 18 and also serves as the gate region of another MOS transistor to be formed in another MOS transistor formation region 14b. It should be noted that the self-alignment technique among silicon gate techniques is utilized to pattern the polycrystalline silicon film 20. In this case, an etchant used for patterning the film 20 stops its etching action when the etchant reaches the gate oxide film 16 or the field insulation layer 12. Subsequently, a p-type impurity such as boron is injected under the same conditions as previously described, thereby forming two p-type high-impurity regions 22 and 24 in a surface layer of the substrate 10 within each of the MOS transistor formation regions 14. The respective high-impurity regions 22 and 24 correspond to the source and drain, respectively, of an MOS transistor. As a result, as clearly shown in Fig. 3C, a p-channel MOS transistor Q1 is prepared. It should be noted that boron ions are injected into the patterned polycrystalline films 20a and 20b as well as into the source and drain regions 22 and 24 within the substrate 10, in accordance with ion injection for forming the source and drain regions.

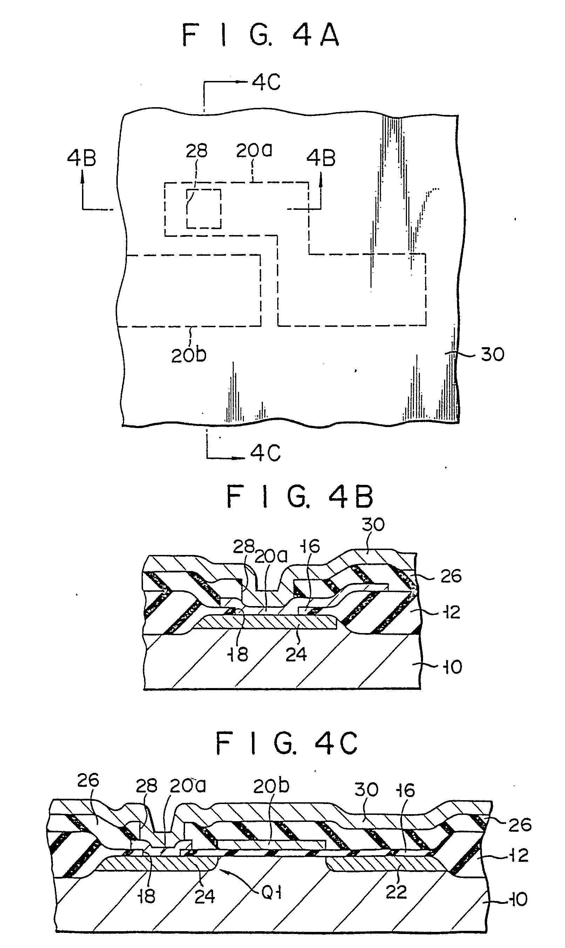

Subsequently, an insulating film 26 such as a plasma CVD—SiO$_2$ film is deposited to cover the entire surface of the structure shown in Fig. 4, to a thickness of, e.g., about 600nm (6,000 Å). An opening 28 serving as another contact hole or drain contact hole is formed in a portion of the film 26 corresponding to the contact hole 18 of the MOS drain region. A second polycrystalline silicon film 30 having a thickness of 300 nm (3,000 Å) is deposited to cover the entire surface of the film 26 having the drain contact hole 28. Therefore, the second polycrystalline silicon film 30 contacts the underlying first polycrystalline silicon film 20a through the drain contact hole 28. The polycrystalline silicon material on the drain region 24 of the MOS transistor Q1 at the position of the contact hole 18 has a total thickness of 600nm (6,000Å), corresponding to the sum of the thicknesses of the first and second polycrystalline layers 20a and 30. The MOS drain region 24 is electrically connected to the second polycrystalline silicon film 30 through the two contact holes, 18, 28 and the first polycrystalline silicon film 20a.

Then, the second polycrystalline silicon film 30 is recrystallized by a rapid annealing technique, such as a laser beam annealing technique, so that the second polycrystalline silicon film 30 is converted to a single-crystalline silicon. In this embodiment, a CW-argon laser was used as an annealing beam source, the raster scan rate was 9.8 cm/sec and the raster scan pitch was set at from 5 to 20 µm. The atmosphere temperature during annealing was kept at a temperature of 490°C, and the laser power was 7 to 15 W. When laser annealing was performed under these conditions, it was found that the second polycrystalline silicon film 30 was effectively recrystallized by using the film portion 30a at the drain contact hole 28 as a seed. In this embodiment, it was found that a suitable laser beam power was in the range between 7 W and 15 W. When the laser power exceeded this range, the second polycrystalline silicon film 30 was melted. However, when the laser power was below this range, the polycrystalline silicon film was not recrystallized. As a result, it was found that the polycrystalline silicon film 30 was sufficiently recrystallized in the laser power range between 7 W and 15 W. When the recrystallized film was observed by an electron diffraction test, Kikuchi lines were clearly observed. Furthermore, when the recrystallized film was observed by electron beam transmission, only a very small amount of polycrystalline silicon was observed. The polycrystalline silicon film 30 was substantially completely recrystallized to single-crystalline silicon.

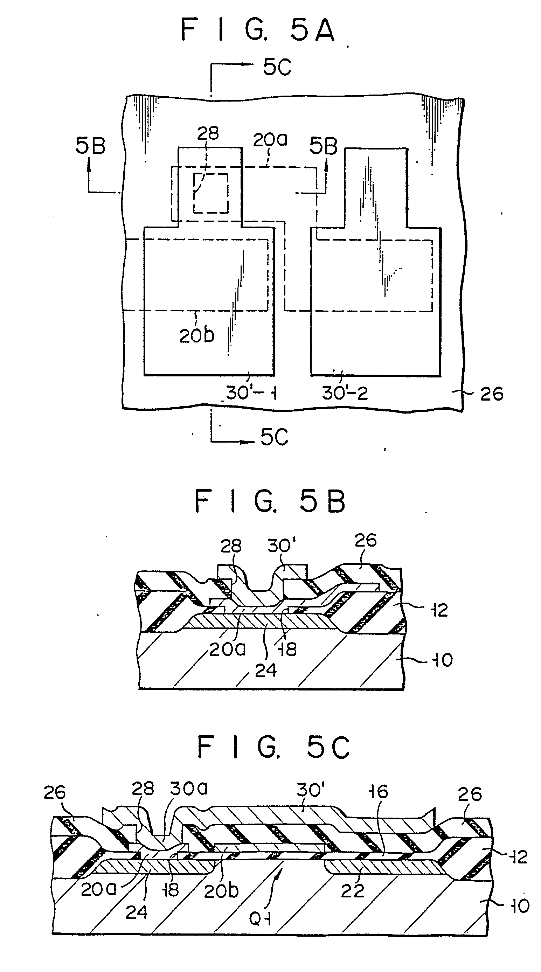

The recrystallized monocrystalline silicon film 30' is then patterned, as shown in Figs. 5A to 5C. Therefore, single-crystalline substrate layers 30'—1 and 30'—2 are prepared for forming bipolar transistors therein, respectively, above the MOS transistors.

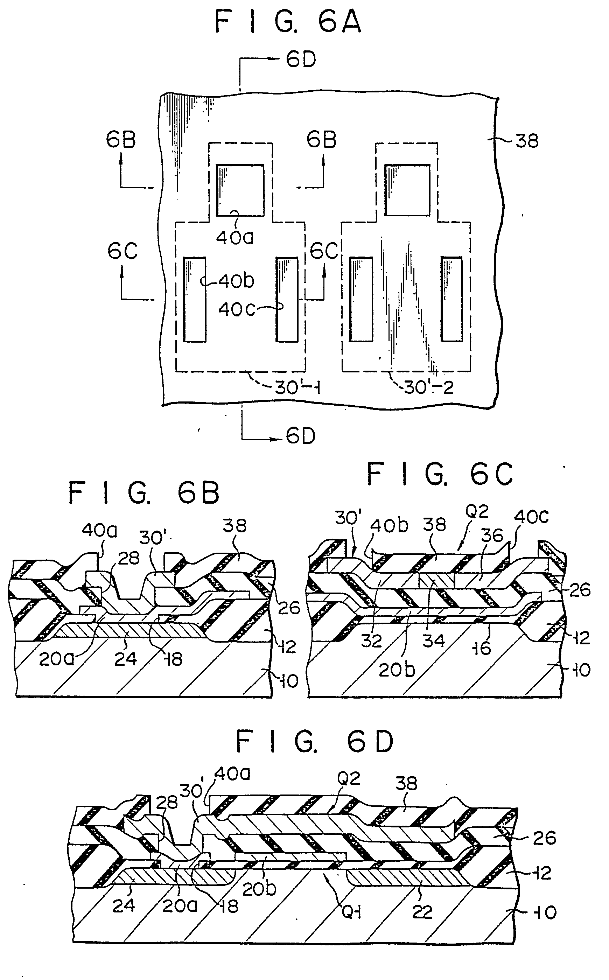

Subsequently, bipolar transistors are formed in the layers 30—1 and 30—2, respectively. For this purpose, arsenic is injected into each of the layers 30'—1 and 30'—2, using a known ion injection mask (not shown). As best illustrated in Fig. 6C, an npn bipolar transistor Q2 having a first n-conductivity type region (emitter region) 32, a p-conductivity type region 34 (base region) 34 and a second n-conductivity type region (collector region) 36 is formed in the layer 30'-1. A bipolar transistor is formed in the layer 30'-2, in the same manner as that formed in the layer 30'-1. The ion injection conditions for forming the pnp junction structure were given as follows: a dose of $1 \times 10^{16}$ cm$^{-2}$ and an ion acceleration voltage of 30 keV at the bipolar transistor emitter region; a dose of $1 \times 10^{11}$ cm$^{-2}$ and an ion acceleration voltage of 50 keV at the collector region; and a dose of $1 \times 10^{16}$ cm$^{-2}$ and an ion acceleration voltage of 50 keV at a portion adjoining a conductive layer (not shown) serving as the collector electrode.

Thereafter, an insulating film 38 made of a CVD—SiO$_2$ film is deposited to cover the entire surface of the structure. Contact holes 40a, 40b, 40c for the base, emitter and collector electrodes, respectively, are formed in the film 38. Wiring pattern layers (not shown) made of aluminum or platinum are deposited to cover the resultant structure and are patterned, thereby obtaining a desired configuration of circuit connections.

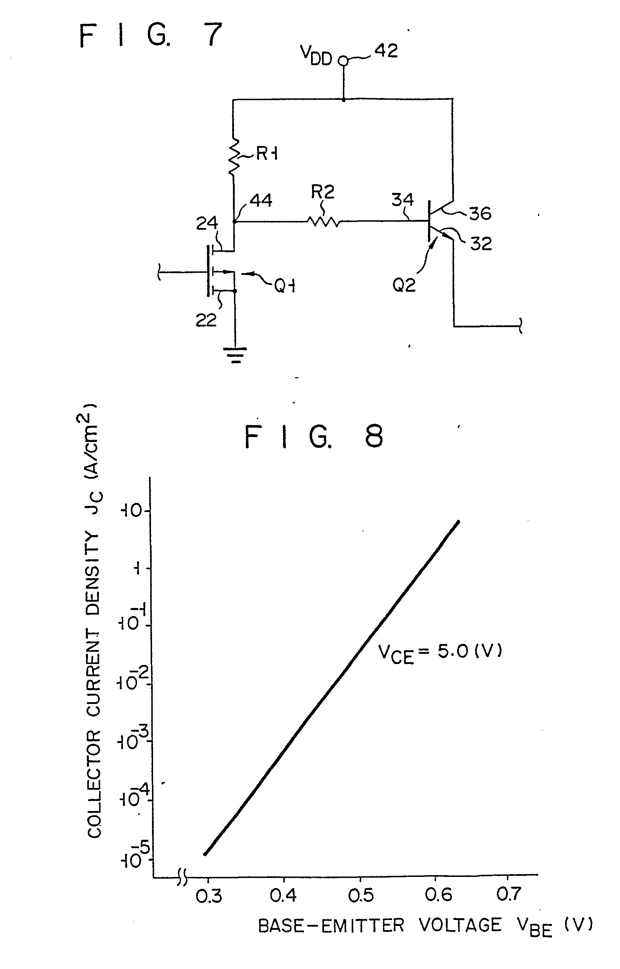

Fig. 7 illustrates an equivalent circuit of a pair of a MOS and a bipolar transistor stacked in a two-storied structure in the semiconductor IC device manufactured as described above. The drain 24 of the underlying MOS transistor Q1 is connected to the collector region 36 of the overlying bipolar transistor Q2 and to a power supply terminal 42, through an equivalent resistor component R1 (including a junction resistance between the layer); and to the base region 34 of the bipolar transistor Q2, through another resistor component R2. A voltage V$_{DD}$ is supplied to the power supply terminal 42. In this embodiment, the resistance R1 between the power supply terminal 42 and the MOS drain 24 was measured to be 7.1 kΩ, while the resistance R2 between the MOS drain 24 and the bipolar base 34 was measured to be 10 kΩ. Under such conditions, the ON resistance of the MOS transistor Q1 was 42.9 kΩ.

When the DC characteristics of the bipolar transistor Q2 were measured, the results shown in Fig. 8 were obtained. A base-emitter voltage V$_{BE}$ is plotted along the axis of the abscissa, and a collector current density J$_C$ is plotted along the axis of the ordinate. A collector-emitter voltage V$_{CE}$ is preset to be 5.0 V. As is apparent from the graph in Fig. 8, the bipolar transistor has good electrical characteristics. When the lifetime of the electrons in the base was measured in accordance with these electrical characteristics, it was found to be $10^{-6}$ sec. This lifetime was substantially the same as that of a transistor formed on a conventional bulk substrate.

The dynamic characteristics of the semiconductor IC device of the described embodiment may be described as follows. The power supply voltage V$_{DD}$ was −5 V, and a voltage which was −1.0 V higher than a threshold voltage was applied to the gate of the MOS transistor Q1, so that the MOS transistor Q1 was rendered conductive. Under such conditions, the potential (i.e., the drain potential) at a node 44 shown in Fig. 7 was measured by calculating the ratio of resistance R1 to the ON resistance of the MOS transistor Q1, and was found to be −4.29 V. Furthermore, the potential at the base was −4.3 V, since the resistance R2 was present between the MOS drain 24 and the bipolar base 34. In this case, the base current was not more than $10^{-6}$ A/cm$^2$, and the collector current J$_C$ was $10^{-4}$ A/cm$^2$, under conditions wherein V$_{BE}$ = 0.7 V. However, when the MOS transistor was rendered nonconductive, the potential at the MOS drain was −4.9 V, the potential at the bipolar base was the same as that of the MOS drain, the base current was not more than $10^{-11}$ A/cm$^2$, and the collector current J$_C$ was $10^{-11}$ A/cm$^2$. Upon ON/OFF operation of the MOS transistor Q1, it was found that the collector current J$_C$ of the bipolar transistor varied in the range between $10^{-4}$ A/cm$^2$, to $10^{-11}$ A/cm$^2$. In other words, it was found that good switching characteristics could be obtained.

According to the embodiment of the present invention, the bipolar transistors Q2 were stereographically (in a two-storied structure) stacked above the MOS transistors Q1 formed on the substrate 10, through the insulating layer. Therefore, the packing density of the circuit with respect to the substrate 10 can be greatly increased. In the device described, it was confirmed by the present inventors that the element area of the substrate could be decreased by about 55%, as compared to that of the conventional two-dimensional IC device having both MOS and bipolar transistors.

Furthermore, all of the MOS transistors can be simultaneously formed on the substrate 10 in the first step. Thereafter, all of the bipolar transistors are simultaneously formed. Therefore, the manufacturing process can be simplified as compared with that of the conventional IC device in which the MOS and bipolar transistors are formed on the same substrate in a mixed manner. The device has better electrical characteristics of the transistor elements, due to the following reasons. First, the bipolar transistors are formed on the MOS transistors in a stacked manner through the insulating layer, so that adverse effects of the thermal hysteresis in the manufacturing process of the bipolar transistors (e.g., changes in impurity distribution in the active impurity regions) tend not to extend to the underlying MOS transistors due to the presence of the $SiO_2$ layer having a small heat conduction. In the conventional device, since the bipolar transistors are adjacent to the MOS transistors, heat in the manufacturing process of the bipolar transistors is directly conducted to the MOS transistors through the substrate, thereby adversely affecting the MOS transistors. Secondly, rapid annealing, such as laser beam annealing, which does not substantially influence the underlying layer, may be used when the bipolar transistors are formed above the MOS transistors. Thirdly, since the bipolar transistors through which large currents flow are positioned above the MOS transistors, heat dissipation of the bipolar transistors can be improved.

An electron beam may be used in place of a CW-argon laser beam in order to anneal and recrystallize the polycrystalline silicon film. The conditions for beam annealing are determined in such a way as to allow for the proper recrystallization of the polycrystalline silicon film and may be arbitrarily modified, as necessary. In the above embodiment, the p-channel enhancement-type transistor is used. However, the present invention may also be applied to an n-channel or depletion-type transistor. The substrate and thin film material are not limited to silicon, but may be extended to any type of semiconductor.

**Claims**

1. A semiconductor device using bipolar transistors (Q2) as first active elements for directly controlling currents, and unipolar transistors (Q1) as second active elements for supplying control signals to said bipolar transistors (Q2), said unipolar and bipolar transistors (Q1, Q2) having different operating modes and being formed on a single semiconductor substrate (10), characterised in that said unipolar transistors (Q1) included in said integrated circuit are directly formed in said substrate (10), that said bipolar transistors (Q2) are stacked above said unipolar transistors (Q1) and that an electrical insulating layer (26) is formed on the unipolar transistors so as to be sandwiched between the unipolar transistors and a single-crystalline semiconductor layer in which said bipolar transistors are formed, said insulating layer (26) being provided with at least one opening in a portion corresponding to the drain region of at least one said unipolar transistor through which said single-crystalline layer (30) is in contact with said drain.

2. A device as claimed in claim 1, characterized in that said unipolar transistors comprise metal oxide semiconductor field effect transistors (Q1) each of which has source and drain regions formed in said substrate (10), while said bipolar transistors, each of which has a base region, comprise junction transistors (Q2).

3. A device as claimed in claim 2, characterized in that the base region (34) of at least one junction bipolar transistor (Q2) positioned immediately above said at least one metal oxide semiconductor field effect transistor (Q1) is connected to the drain region (24) of said at least one field effect transistor (Q1) through the contact hole (28) of said insulating layer (26).

4. A device as claimed in claim 4, characterized in that said single-crystalline semiconductor layer is converted by recrystallization from a polycrystalline semiconductor material to a single-crystalline semiconductor material.

5. A device as claimed in claim 5, characterized by further comprising a polycrystalline film (20a) formed between the drain region (24) of said at least one metal oxide semiconductor field effect transistor (Q1) formed on said substrate (10) and at least one layer component (30'-1) of said semiconductor layer components (30'-1, 30'-2), which contains therein said at least one junction bipolar transistor (Q2) having the base region (34) connected to the drain region (24) of said at least one metal oxide semiconductor field effect transistor (Q1), said polycrystalline film (20a) being implanted with ions of a suitable impurity.

6. The device as recited in claim 5, characterized in that said polycrystalline silicon film (20a) extends under said insulating layer (26), thereby serving as a gate electrode of an adjacent metal oxide semiconductor field effect transistor (Q2).

7. A semiconductor integrated circuit device having a single-crystalline semiconductor substrate (10) having a surface portion, wherein said device comprises metal oxide semiconductor field effect transistors (Q1) which are directly formed in said substrate and include at least one pair of first and second field effect transistors (Q1) adjacent to each other, each of said field effect transistors having source and drain regions (22, 24) formed in the surface portion of said substrate (10), and a gate electrode; a conductive layer (20a) provided in such a way as to constitute the gate electrode of the first field effect transistor and to electrically connect the gate electrode of said first field effect transistor (Q1) with a drain region (24) of said second field effect transistor; a first insulating layer formed on said field effect transistors (Q1) and said conductive layer (20a) and having a contact hole (28) at a portion thereof corresponding to at least the drain region (24) of the second field effect transistor; single-crystalline semiconductor layers (30'-1, 30'-2) formed of said insulating layer (26) and above said field effect transistors (Q1), respectively, said semiconductor layers including a single-crystalline semiconductor layer (30'-1) which is formed above the second field effect transistor and is electrically connected to the drain region (24) of the second field effect transistor through the contact hole (28) of said insulating layer (26); and junction bipolar transistors (Q2) respectively formed in said single-crystalline semiconductor layers (30'-1), 30'-2) so as to have base, emitter and collector regions (34, 32, 36), said bipolar transistors including a junction bipolar transistor (Q2) having a base region (34) connected to the drain region (24) of said second field effect transistor (Q1) through said conductive layer (20b) and the contact hole (28) of said insulating layer (26).

8. The device as recited in claim 7, characterized in that said conductive layer comprises a polycrystalline silicon layer onto which ions of a suitable impurity are implanted and said first insulating layer comprises a silicon oxide layer.

9. The device as recited in claim 8, characterized by further comprising a second insulating layer (38) formed on said first insulating layer (26) and said single-crystalline semiconductor layer (30') having said bipolar transistors (Q2) formed therein, and having contact holes (40a, 40b, 40c) at portions thereof respectively corresponding to the base, emitter and collector regions (34, 32, 36) of said bipolar transistors (Q2).

10. A method for manufacturing a semiconductor device constituted by an integrated circuit including unipolar transistors, such as metal oxide semiconductor field effect transistors (Q1), and bipolar transistors, such as junction transistors (Q2) having a predetermined conductivity type, said unipolar and bipolar transistors being formed on a semiconductive substrate (10), characterized by comprising the steps of simultaneously forming, in said substrate (10), metal oxide semiconductor field effect transistors (Q1) which have drain regions (24) and which are included in said integrated circuit; depositing an electrical insulating layer (26) on said metal oxide semiconductor field effect transistors (Q1); forming contact holes (28) in portions of said insulating layer (26), which respectively correspond to the drain regions (24) of said metal oxide semiconductor field effect transistors (Q1); forming a single-crystalline silicon layer (30) to cover a resultant structure and patterning said single-crystalline silicon layer (30) to obtain single-crystalline silicon layer components (30'-1, 30'-2) respectively corresponding to said field effect transistors (Q1); and simultaneously forming junction bipolar transistors (Q2) in said single-crystalline silicon layer components (30'-1, 30'-2) respectively, said junction bipolar transistors (Q2) being included in said integrated circuit.

11. The method as recited in claim 10, characterised in that said single-crystalline silicon layer forming step comprises forming a polycrystalline silicon layer (30) to cover said resultant structure, and recrystallizing said polycrystalline silicon layer (30) in accordance with a beam annealing technique, thereby converting said polycrystalline silicon layer (30) to said single-crystalline silicon layer (30').

12. The method as recited in claim 11, characterised in that said junction bipolar transistors forming step comprises implanting ions into said single-crystalline silicon layer components (30'-1, 30'-2) such that said junction bipolar transistors (Q2) respectively have base regions (34) connected to the drain regions (24) of said metal oxide semiconductor field effect transistors (Q1).

## Patentansprüche

1. Halbleiteranordnung unter Verwendung von Bipolartransistoren (Q2) als erste aktive Elemente zum direkten Regeln von Strömen und Unipolartransistoren (Q1) als zweite aktive Elemente zum Zuspeisen von Steuer- oder Regelsignalen zu den Bipolartransistoren (Q2), wobei die Unipolartransistoren und Bipolartransistoren (Q1, Q2) unterschiedliche Betriebsarten aufweisen und auf einem einzigen Halbleitersubstrat (10) ausgebildet sind, dadurch gekennzeichnet, daß die im integrierten Schaltkreis enthalten Unipolartransistoren (Q1) unmittelbar im Substrat (10) geformt sind, daß die Bipolartransistoren (Q2) (stapelartig) über den Unipolartransistoren (Q1) angeordnet sind und daß eine elektrische Isolierschicht (26) auf den Unipolartransistoren so ausgebildet ist, daß sie zwischen die Unipolartransistoren und eine einkristalline Halbleiterschicht eingefügt ist, in welcher die Bipolartransistoren ausgebildet sind, wobei die Isolierschicht (26) in einem Bereich entsprechend der Drainzone mindestens eines Unipolartransistors mit mindestens einer Öffnung versehen ist, über welche die einkristalline Schicht (30) mit der Drainelektrode in Kontakt steht.

2. Anordnung nach Anspruch 1, dadurch gekennzeichnet, daß die Unipolartransistoren Metalloxidhalbleiter-Feldeffekttransistoren (Q1) mit jeweils im Substrat (10) ausgebildeten Source- und Drainzonen sind, während die jeweils eine Basiszone aufweisenden Bipolartransistoren Flächentransistoren (Q2) sind.

3. Anordnung nach Anspruch 2, dadurch gekennzeichnet, daß die Basiszone (34) mindestens eines Flächenbipolartransistors (Q2), der unmittelbar über dem mindestens einen Metalloxidhalbleiter-Feldeffekttransistor (Q1) angeordnet ist, durch das Kontaktloch (28) der Isolierschicht (26) hindurch mit der Drainzone (24) des mindestens einem Feldeffekttransistors (Q1) verbunden ist.

4. Anordnung nach Anspruch 4, dadurch gekennzeichnet, daß die einkristalline Halbleiterschicht durch Umkristallisation aus einem polykristallinen Halbleitermaterial in eine einkristallines Halbleitermaterial umgewandelt ist.

5. Anordnung nach Anspruch 5, gekennzeichnet durch einen polykristallinen Film (20a), der zwischen der Drainzone (24) des mindestens einen, auf dem Substrat (10) geformten Metalloxidhalbleiter-Feldeffekttransistors (Q1) und mindestens einem Schichtbestandteil (30'-1) der Halbleiterschichtbestandteile (30'-1, 30'-2) geformt ist, welcher den mindestens einen Flächenbipolartransistor (Q2) enthält, dessen Basiszone (34) mit der Drainzone (24) des minde-

stens einen Metalloxidhalbleiter-Feldeffekt-transistors (Q1) verbunden ist, wobei in den polykristallinen Film (20a) Ionen eines geeigneten Fremdatoms implantiert sind.

6. Anordnung nach Anspruch 1, dadurch gekennzeichnet, daß sich der polykristalline Siliziumfilm (20a) unter die Isolierschicht (26) erstreckt und damit als Gateelektrode eines benachbarten Metalloxidhalbleiter-Feldeffekttransistors (Q2 bzw. Q1) dient.

7. Integrierte Halbleiterschaltungsanordnung mit einem einkristallinen Halbleitersubstrat (10) mit einem (Ober-)Flächenabschnitt, umfassend Metalloxidhalbleiter-Feldeffekttransistoren (Q1), die unmittelbar im Substrat ausgebildet sind und mindestens zwei erste und zweite, einander benachbarte Feldeffekttransistoren (Q1) aufweisen, von denen jeder im Flächenabschnitt des Substrats (10) geformte Source- und Drainzonen (22, 24) sowie eine Gateelektrode aufweist, eine leitfähige Schicht oder Leiterschicht (20a) die so vorgesehen ist, daß sie die Gateelektrode des ersten Feldeffekttransistors bildet und die Gateelektrode des ersten Feldeffekttransistors (Q1) elektrisch mit einer Drainzone (24) des zweiten Feldeffekttransistors verbindet, eine auf den Feldeffekttransistoren (Q1) und der Leiterschicht (20a) ausgebildete erste Isolierschicht mit einem Kontaktloch (28) in einem Bereich derselben, welcher zumindest der Drainzone (24) des zweiten Feldeffekttransistors entspricht, auf der Isolierschicht (26) und über den jeweiligen Feldeffekttransistoren (Q1) ausgebildete einkristalline Halbleiterschichten (30'-1, 30'-2), die eine einkristalline Halbleiterschicht (30'-1) enthalten, welche über dem zweiten Feldeffekttransistor ausgebildet und durch das Kontaktloch (28) der Isolierschicht (26) hindurch elektrisch mit der Drainzone (24) des zweiten Feldeffekttransistors verbunden ist, und jewils in den einkristallinen Halbleiterschichten (30'-1, 30'-2) erzeugte Flächenbipolartransistoren (Q2) mit jeweils Basis-, Emitter- und Kollektorzonen (34, 32, 36), wobei die Bipolartransistoren einen Flächenbipolartransistor (Q2) mit einer Basiszone (34) umfassen, die über die Leiterschicht (20b bzw. 20a) und das Kontaktloch (28) der Isolierschicht (26) mit der Drainzone (24) des zweiten Feldeffekttransistors (Q1) verbunden ist.

8. Anordnung nach Anspruch 7, dadurch gekennzeichnet, daß die Leiterschicht eine polykristalline Siliziumschicht aufweist, in die Ionen eines geeigneten Fremdatoms implantiert sind, und die erste Isolierschicht eine Siliziumoxidschicht ist.

9. Anordnung nach Anspruch 8, dadurch gekennzeichnet, daß eine zweite, auf den ersten Isolierschicht (26) ausgebildete Isolierschicht (38) vorgesehen ist und in der einkristallinen Halbleiterschicht (30') die Bipolartransistoren (Q2) erzeugt und Kontaktlöcher (40a, 40b, 40c) in Abschnitten derselben ausgebildet sind, welche jeweils Basis-, Emitter und (bzw.) Kollektorzonen (34, 32, 36) der Bipolartransistoren (Q2) entsprechen.

10. Verfahren zur Herstellung einer Halbleiteranordnung aus einem integrierten Schaltkreis mit Unipolartransistoren, wie Metalloxidhalbleiter-Feldeffekttransistoren (Q1), und Bipolartransistoren, wie Flächentransistoren (Q2) eines vorbestimmten Leitfähigkeitstyps, wobei die Unipolar- und Bipolartransistoren auf einem Halbleitersubstrat (10) ausgebildet sind, dadurch gekennzeichnet, daß im Substrat (10) gleichzeitig Metalloxidhalbleiter-Feldeffekttransistoren (Q1) erzeugt werden, die Drainzonen (24) aufweist und in den intergrierten Schaltkreis einbezogen sind, eine elektrische Isolierschicht (26) auf den Metalloxidhalbleiter-Feldeffekttransistoren (Q1) abgelagert bzw. auf diese aufgedampft wird, Kontaktlöcher (28) in Abschnitten der Isolierschicht (26) geformt werden, welche jeweils den Drainzonen (24) der Metalloxidhalbleiter-Feldeffekttransistoren (Q1) entsprechen, eine einkristalline Siliziumschicht (30) das erhaltene Gebilde bedeckend geformt und die einkristalline Siliziumschicht (30) gemustert wird, um einkristalline Siliziumschichtbestandteile (30'-1, 30'-2) zu erhalten, die jeweils den Feldeffekttransistoren (Q1) entsprechen, und in den jeweiligen einkristallinen Siliziumschichtbestandteilen (30'-1, 30'-2) gleichzeitig Flächenbipolartransistoren (Q2), die in den integrierten Schaltkreis einbzeogen sind, ausgebildet werden.

11. Verfahren nach Anspruch 10, dadurch gekennzeichnet, daß der Schritt der Ausbildung der einkristallinen Siliziumschicht die Erzeugung einer das erhaltene Gebilde bedeckenden polykristallinen Siliziumschicht (30) und die Umkristallisierung der polykristallinen Siliziumschicht (30) nach einer Strahlgühtechnik, um damit die polykristalline Siliziumschicht (30) in die einkristalline Siliziumschicht (30') umzuwandeln, umfaßt.

12. Verfahren nach Anspruch 11, dadurch gekennzeichnet, daß der Schritt der Ausbildung der Flächenbipolartransistoren das Implantieren von Ionen in die einkristallinen Siliziumschichtbestandteile (30'-1, 30'-2) in der Weise, daß die Flächenbipolartransistoren (Q2) jeweils mit den Drainzonen (24) der Metalloxidhalbleiter-Feldeffekttransistoren (Q1) verbundene Basiszonen (34) aufweisen, umfaßt.

## Revendications

1. Dispositif à semi-conducteur mettant en oeuvre des transistors bipolaires (Q2) constituant les premiers éléments actifs destinés à commander directement des courants, et des transistors unipolaires (Q1) constituant des seconds éléments actifs et destinés à transmettre des signaux de commande aux transistors bipolaires (Q2), les transistors unipolaires et bipolaires (Q1, Q2) ayant des modes différents de fonctionnement et étant formés sur un substrat semi-conducteur unique (10), caractérisé en ce que les transistors unipolaires (Q1) incorporés au circuit intégré sont formés directement dans la substrat (10), en ce que les transistors bipolaires (Q2) sont empilés sur les transistors unipolaires (Q1), et en ce qu'une couche d'isolement électrique (26) est formée sur les transistors unipolaires afin qu'elle soit disposée entre les transistors unipolaires et une couche semi-conductrice monocristalline dans laquelle des transistors bipolaires sont formés, la couche isolante (26) ayant au moins une ouverture placée dans une partie correspondant à la région de drain d'au moins un transistor unipolaire et par laquelle la couche monocristalline (30) est au contact du drain.

2. Dispositif selon la revendication 1, caractérisé en ce que les transistors unipolaires sont des transistors à effet de champ du type métal-oxyde-semi-conducteur (Q1) ayant chacun des régions de source et de drain formées dans le substrat (10), alors que les transistors bipolaires, ayant chacun une région de base, sont des transistors à jonction (Q2).

3. Dispositif selon la revendication 2, caractérisé en ce que la région de base (34) d'au moins un transistor bipolaire à jonction (Q2) placé juste au-dessus du transistor à effet de champ du type métal-oxyde-semi-conducteur au moins (Q1) est connectée à la region de drain (24) du transistor à effet de champ au moins (Q1) par l'intermédiaire du trou de contact (28) de la couche isolante (26).

4. Dispositif selon la revendication 4, caractérisé en ce que la couche semi-conductrice monocristalline est transformée par recristallisation d'un matériau semi-conducteur polycristallin en un matériau semi-conducteur monocristallin.

5. Dispositif selon la revendication 5, caractérisé en ce qu'il comporte en outre un film polycristallin (20a) formé entre la région de drain (24) du transistor à effet de champ du type métal-oxyde-semi-conducteur au moins (Q1) formé sur le substrat (10) et au moins un élément de couche (30'-1) des éléments de couche semi-conductrice (30'-1, 30'-2) qui contiennent le transistor bipolaire à jonction au moins (Q2) ayant sa région de base (34) connectée à la région de drain (24) du transistor à effet de champ du type métal-oxyde-semi-conducteur au moins (Q1), le film polycristallin (20a) étant implanté d'ions d'une impureté convenable.

6. Dispositif selon la revendication 5, caractérisé en ce que le film de silicium polycrystallin (20a) est disposé sous la couche isolante (26), et est ainsi utilisé comme électrode de grille d'un transistor à effet de champ du type métal-oxyde-semi-conducteur adjacent (Q2).

7. Dispositif à circuit intégré à semi-conducteur ayant un substrat semi-conducteur monocristallin (10) qui a une partie de surface, dans lequel le dispositif comporte des transistors à effet de champ du type métal-oxyde-semi-conducteur (Q1) qui sont directement formés dans le substrat et qui comprennent au moins une paire d'un premier et d'un second transistor à effet de champ (Q1) adjacents l'un à l'autre, chacun des transistors à effet de champ ayant des régions de source et de drain (22, 24) formées dans la partie de surface du substrat (10), et une électrode de grille, une couche conductrice (20a) disposée de manière qu'elle constitue l'électrode de grille du premier transistor à effet de champ et qu'elle connecte électriquement l'électrode de grille du premier transistor à effet de champ (Q1) à une région de drain (24) du second transistor à effet de champ, une première couche isolante formée sur les transistors à effet de champ (Q1) et la couche conductrice (20a) et ayant un trou de contact (28) dans une partie qui correspond à au moins une région de drain (24) du second transistor à effet de champ, des couches semi-conductrices monocristallines (30'-1, 30'-2) formées sur la couche isolante (26) et au-dessus des transistors à effet de champ (Q1) respectivement, les couches semi-conductrices comprenant une couche semi-conductrice monocristalline (30'-1) qui est formée au-dessus du second transistor à effet de champ et qui est connectée électriquement à la région de drain (24) du second transistor à effet de champ par l'intermédiaire du trou de contact (28) de la couche isolante (26), et des transistors bipolaires (Q2) à jonction formés respectivement dans les couches semi-conductrices monocristallines (30'-1, 30'-2) afin qu'ils possèdent des régions de base, d'émetteur et de collecteur (34, 32, 36), les transistors bipolaires comprenant un transistor bipolaire (Q2) à jonction ayant une région de base (34) connectée à la région de drain (24) du second transistor à effet de champ (Q1) par l'intermédiaire de la couche conductrice (20b) et du trou de contact (28) formé dans la couche isolante (26).

8. Dispositif selon la revendication 7, caractérisé en ce que la couche conductrice comporte une couche de silicium polycristallin dans laquelle des ions d'une impureté convenable sont implantés, et la première couche isolante est une couche d'oxyde de silicium.

9. Dispositif selon la revendication 8, caractérisé en ce qu'il comprend en outre une seconde couche isolante (38) formée sur la première couche isolante (26) et la couche semi-conductrice monocristalline (30') dans laquelle sont formés les transistors bipolaires (Q2), et ayant des trous de contact (40a, 40b, 40c) dans des parties correspondant respectivement aux régions de base, d'émetteur et de collecteur (34, 32, 36) des transistors bipolaires (Q2).

10. Procédé de fabrication d'un dispositif à semi-conducteur constitué par un circuit intégré, comprenant des transistors unipolaires, par exemple des transistors à effet de champ du type métal-oxyde-semi-conducteur (Q1), et des transistors bipolaires, par exemple des transistors à jonction (Q2) ayant un type prédéterminé de conductivité, les transistors unipolaires et bipolaires étant formés sur un substrat semi-conducteur (10), caractérisé en ce qu'il comprend les étapes de formation simultanée, dans le substrat (10), de transistors à effet de champ du type métal-oxyde-semi-conducteur (Q1) qui ont des régions de drain (24) et qui sont incorporés au circuit intégré, de dépôt d'une couche (26) isolante de l'électricité sur les transistors à effet de champ du type métal-oxyde-semi-conducteur (Q1), de formation de trous de contact (28) dans des parties de la couche isolante (26), correspondant respectivement aux régions de drain (24) des transistors à effet de champ du type métal-oxyde-semi-conducteur (Q1), de formation d'une couche de silicium monocristallin (30) destinée à recouvrir la structure résultante, et de formation d'un dessin dans la couche de silicium monocristallin (30) afin que des éléments de couche monocrystalline (30'-1, 30'-2) soient obtenus et correspondent respectivement aux transistors à effet de champ (Q1), et de formation simultanée de transistors bipolaires à jonction (Q2) dans les éléments de couche de silicium monocristallin (30'-1, 30'-2) respectivement, les transistors bipolaires (Q2) à jonction étant incorporés au circuit intégré.

11. Procédé selon la revendication 10, caractérisé en ce que l'étape de formation d'une couche de silicium monocristallin comporte la formation d'une couche (30) de silicium polycristallin destinée à recouvrir la structure résultante, et la recristallisation de la couche de silicium polycristallin (30) par une technique de recuit par un faisceau, afin que la couche (30) de silicium polycristallin se transforme en une couche (30') de silicium monocristallin.

12. Procédé selon la revendication 11, caractérisé en ce que l'étape de formation de transistors bipolaires à jonction comprend l'implantation d'ions dans les éléments (30'-1, 30'2) de couche de silicium monocristallin afin que les transistors bipolaires (Q2) à jonction aient des régions de base (34) connectées aux régions de drain (24) des transistors à effet de champ du type métal-oxyde-semi-conducteur (Q1).

F I G. 1A

F I G. 1B

F I G. 2A

F I G. 2B

# F I G. 3A

# F I G. 3B

# F I G. 3C

# F I G. 4A

4C

4B        28    20a    4B

20b

30

# F I G. 4B

30

28 20a  16

26

12

18    24    10

# F I G. 4C

26  28 20a    20b    30  16

26

12

18  24  Q1    22    10

# F I G. 5A

# F I G. 5B

# F I G. 5C

# F I G. 6A

6D

6B     6B

6C     6C

38

40a

40b
40c

30'-1     30'-2

6D

# F I G. 6B

40a   30'    38
28
26
12
20a   24   18
10

# F I G. 6C

30'   40b   38   Q2   36   40c
26
32   34   16   12
20b
10

# F I G. 6D

30'   40a    Q2    38
28
26
12
24   20a   18   20b   Q1   22
10

5

# F I G. 7

# F I G. 8

COLLECTOR CURRENT DENSITY $J_C$ (A/cm$^2$)

$V_{CE} = 5.0$ (V)

BASE-EMITTER VOLTAGE $V_{BE}$ (V)